# EUROPEAN PATENT SPECIFICATION

(11) **EP 1 674 587 B1**
(45) Date of publication and mention of the grant of the patent: **07.01.2009**
(21) Application number: 05027541.1
(22) Date of filing: 15.12.2005
(51) Int. Cl.: C22C 9/00

(54) **Copper alloy having bendability and stress relaxation property**
Kupferlegierung mit guten Eigenschaften bezüglich Biegbarkeit und Spannungsrelaxation
Alliage de cuivre avec aptitude au pliage et resistance à la relaxation en contraintes ameliorées

(30) Priority: 24.12.2004 JP 2004374161; 16.09.2005 JP 2005270695
(43) Date of publication of application: 28.06.2006
(73) Proprietor: KABUSHIKI KAISHA KOBE SEIKO SHO, Kobe-shi, Hyogo 651-8585 (JP)
(72) Inventor: Aruga, Yasuhiro Kobe Corporate Research Lab., Nishi-ku Kobe-shi Hyogo 651-2271 (JP); Ozaki,Ryoichi, Int. Prop. Dept. in Kobe Steel Ltd., Kobe-shi, Hyogo 651-2271 (JP); Sakamoto,Hiroshi, Int.Prop.Dept. in Kobe Steel Ltd, Kobe-shi, Hyogo 651-2271 (JP)
(74) Representative: Müller-Boré & Partner Patentanwälte

(56) References cited:
- WO-A-99/05331
- JP-A- 6 073 474
- JP-A- 58 199 835
- JP-A- 2000 017 355
- US-A- 4 305 762
- US-A- 4 605 532

## Description

The present invention relates to copper alloys having bendability and stress relaxation property. Specifically, it relates to copper alloys suitable as raw materials for copper alloy sheets for use in semiconductor components such as IC lead frames for semiconductor devices; materials for electric/electronic components such as printed wiring boards; switch components; and mechanical components such as bus-bars, terminals, and connectors.

Cu-Fe-P alloys have been generally used as copper alloys for the above applications such as IC lead frames for semiconductor devices. Examples of these Cu-Fe-P alloys include a copper alloy (C19210 alloy) containing 0.05% to 0.15% of Fe and 0.025% to 0.040% of P and a copper alloy (CDA194 alloy) containing 2.1% to 2.6% of Fe, 0.015% to 0.15% of P, and 0.05% to 0.20% of Zn. Among copper alloys, these Cu-Fe-P alloys exhibit high strength, high electrical conductivity, and high thermal conductivity when an intermetallic compound of, e.g., Fe or Fe and P, is dispersed in a copper matrix, and therefore, these have been generally used as the international standard alloys.

With increasing applications, Cu-Fe-P alloys must have such properties as to maintain contact fitting force in a hot environment, i.e., so-called stress relaxation property, as properties to ensure the reliability in a hot environment. Specifically, when coupling components are placed in a hot environment such as an engine room of an automobile, the stress is relaxed and contact pressure decreases with elapse of time, and the contact resistance at a junction tends to increase. Thus, the coupling components lose their contact fitting force. Consequently, the "stress relaxation property" is resistant properties against the reduction in contact fitting force (stress). It is believed that the stress relaxation property improves with a decreasing stress relaxation rate.

Various techniques have been proposed in order to improve the stress relaxation property. Japanese Patent No. 2977839, for example, discloses a copper alloy for electric/electronic components, containing 0.1 to 1.0 percent by weight of Sn, 0.02 to 0.50 percent by weight of Fe, 0.01 to 0.1 percent by weight of P, 0.3 to 1.5 percent by weight (excluding 1.5 percent by weight) of Zn, and 0.1 to 1.0 percent by weight of Mg, with the remainder substantially being Cu. According to this technique, Fe and P are added together to form iron phosphide to thereby improve the spring limit. In addition, the copper alloy is to have softening resistance, particularly excellent creep properties at elevated temperatures, and stress relaxation property.

Japanese Unexamined Patent Application Publication No. 2002-294368 proposes a copper alloy for terminals and connectors, containing 0.8% to 1.5% of Ni, 0.5% to 2.0% of Sn, 0.015% to 5.0% of Zn, and 0.005% to 0.1% of P, in which the areal ratio of precipitates is 5% or less to maintain the resistance of the parent phase against stress relaxation (activity for inhibiting migration of slipband and dislocation disappearance) and to improve the stress relaxation property.

The Cu-Fe-P alloys for the above-mentioned applications are required to have excellent bendability capable of enduring sharp bending such as U-bending or 90° bending after notching, as well as the high strength and the high electrical conductivity.

However, the above-described addition of solid-solution hardening elements such as Sn and Mg, or the increase in strength by increasing reduction ratios of the cold rolling inevitably cause deterioration of the bendability and, therefore, the required strength and the bendability cannot become mutually compatible.

On the other hand, it is known that the bendability can be improved to some extent by grain refining or by controlling the state of dispersoids (Japanese Unexamined Patent Application Publication No. 6-235035 and Japanese Unexamined Patent Application Publication No. 2001-279347). However, in order to produce a Cu-Fe-P alloy material having high strength compatible with reduction in the size and weight of components in recent years, an increase in the quantity of work hardening by increasing reduction ratio of the cold rolling becomes indispensable.

Consequently, as for the above-described high strength materials, the bendability cannot be adequately improved against the above-described sharp bending such as U-bending or 90° bending after notching, by means of microstructure control, e.g., grain refining or control of the state of dispersoids, disclosed in Japanese Unexamined Patent Application Publication No. 6-23503 and Japanese Unexamined Patent Application Publication No. 2001-279347.

As for Cu-Fe-P alloys, Japanese Unexamined PatentApplication Publication No. 2002-339028 proposes control of the microstructure. Specifically, it proposes that an intensity ratio, I (200)/I(220), of diffraction of (200) to diffraction of (220) is 0.5 or more and 10 or less, the density of Cube orientation is 1 or more and 50 or less, or a ratio of the density of Cube orientation to the density of S orientation is 0.1 or more and 5 or less.

Japanese Unexamined Patent Application Publication No. 2000-328157 proposes that an intensity ratio, [I(200) + I(311)]/I(220), of the sumof diffraction of (200) and diffraction of (311) to diffraction of (220) is 0.4 or more.

The conventional techniques such as adjusting the alloying component in Japanese Patent No. 2977839 and reducing the areal ratio of precipitates in Japanese Unexamined Patent Application PublicationNo. 2002-294368 are insufficient to improve the stress relaxation property. These techniques cannot make the alloy to have bendability simultaneously.

The control of the microstructure in Japanese Unexamined Patent Application Publication No. 2002-339028 and Japanese Unexamined Patent Application Publication No. 2000-328157 do not achieve the excellent stress relaxation property, although they yield improved bendability.

US-A-4,605,532 describes a copper base alloy having an improved combination of conductivity and strength for applications such as lead frames or electrical connectors, wherein the alloys consists essentially of about 0.3 to 1.6% by weight of iron, with up to one-half the iron content being replaced by nickel, manganese, cobalt, and mixtures thereof; about 0.01 to about 0.20% by weight of magnesium; about 0.10 to about 0.40% by weight of phosphorus; up to about 0.5% by weight of tin or antimony and mixtures thereof; and the balance being copper.

JP-6-73474 discloses a copper alloy comprising, in weight percent, 0.15 to 0.50% Fe, >0.10 to 0.35% P, 0.05 to 0.30% Mg and 0.3 to 3.0% Zn and optionally containing 0.01 to 1.0% Sn, and the balance being Cu and inevitable impurities, wherein the ratio (weight percent ratio) of Fe:P:Mg = (5.5 to 6.5) : (4.5 to 5.5) : (3.5 to 4.5), and further containing Fe₂P and Mg₃P₂ precipitates.

Accordingly, an object of the present invention is to provide a Cu-Fe-P alloy having excellent bendability compatible with excellent stress relaxation property.

The solution to the above technical problem is achieved by providing the subject matter defined in the claim.

In particular, there is provided a copper alloy having bendability and stress relaxation property and comprising, in wt.%: 0.01 to 1.0% Fe, 0.01 to 0.4% P, 0.1 to 1.0% Mg, optionally 0.01 to 1.0% of at least one of Ni and Co, and/or 0.005 to 3.0% Zn and/or 0.01 to 5.0% Sn and/or 1.0% or less of a total content of Mn, Ca, Zr, Ag, Cr, Cd, Be, Ti, Co, Ni, Au and Pt and/or 0.1 % or less of a total content of Hf, Th, Li, Na, K, Sr, Pd, W, S, Si, C, Nb, Al, V, Y, Mo, Pb, In, Ga, Ge, As, Sb, Bi, Te, B, and misch metal and the remainder being Cu and inevitable impurities, wherein the volume fraction of dispersoids with particle diameters exceeding 200 nm is 5% or less, the dispersoids having a particle diameter of 200 nm or less and containing Mg and P have an average particle diameter of 5 to 50 nm and the dispersoids having a particle diameter of 200 nm or less and containing Fe and P have an average particle diameter of 1 to 20 nm.

To further improve the bendability and the stress relaxation property, dispersoids each having a particle diameter of 200 nm or less and containing Fe and P have an average particle diameter of 1 nm or more and 20 nm or less.

The copper alloy can contain 0.01 to 1.0 percent by mass of at least one of Ni and Co to further improve the bendability and the stress relaxation property.

The copper alloy can contain 0.005 to 3.0 percent by mass of Zn for improving thermal ablation resistance of Sn plating and solder to thereby prevent thermal ablation (heat peeling) . The Zn content is preferably 0.005 to 1.5 percent by mass to avoid reduction in electrical conductivity.

To improve the strength, the copper alloy can contain 0.01 to 5.0 percent by mass of Sn. The Sn content is preferably 0.01 to 1.0 percent by mass to avoid reduction in electrical conductivity.

According to the aspect of the present invention, a Cu-Fe-P alloy is combined with Mg to have improved strength and improved stress relaxation property and to reduce coarse dispersoids having a particle diameter exceeding 200 nm.

The coarse dispersoids having a particle diameter exceeding 200 nm accelerate recrystallization in a hot environment to thereby reduce the stress relaxation property, cause breakage in deformation and promote crack propagation to thereby reduce the bendability.

To further effectively improve the bendability and the stress relaxation property by the addition of Mg in the Cu-Fe-P alloy, dispersoids containing Mg and P (Mg-P particles) should have an average particle diameter of 5 nm or more and 50 nm or less. These fine Mg-P particles prevent migration of dislocation and grain growth to thereby highly effectively improve the bendability and the stress relaxation property.

Such effects and influence of these fine Mg-P particles on the properties of Cu-Fe-P alloys have been first found by the present inventors.

The term "dispersoid containing Mg and P" used herein means a dispersoid containing Mg and P in a total content of 60% or more of the total components in the particle. Likewise, the term "dispersoid containing Fe and P" means a dispersoid containing Fe and P in a total content of 60% or more of the total components in the particle.

### Composition of Copper Alloy

The chemical composition of the Cu-Fe-P alloy of the present invention suitable for satisfying the required strength and the electrical conductivity and further satisfying the excellent bendability and the excellent stress relaxation property will be described below.

In the present invention, as for the basic composition to achieve the high strength, high electrical conductivity, high bendability, and high stress relaxation property, the copper alloy comprises 0.01 to 1.0 percent by mass of Fe, 0.01 to 0.4 percent by mass of P, and 0.1 to 1.0 percent by mass of Mg, with the remainder being copper and inevitable impurities.

In another embodiment, the following range of at least one of Ni and Co and/or at least one of Zn and Sn may be further contained relative to this basic composition. Other impurity elements may be contained within the ranges of not impairing these properties.

### (Fe)

Iron (Fe) precipitates as Fe or a Fe-P dispersoid having a particle diameter of 200 nm or less, and is an important element which improves the strength and the stress relaxation property of the copper alloy. If the content of Fe is less than 0.01 percent by mass, the quantity of generation of the above-described fine dispersoids is small. The content of Fe should be 0.01 percent by mass or more to effectively exhibit these advantages. On the other hand, if the content of Fe exceeds 1.0 percent by mass, dispersoids are grown and become coarse, so that the strength, the bendability, and the stress relaxation property are reduced. Therefore, the content of Fe is specified to be within the range of 0.01 to 1.0 percent by mass.

### (P)

Phosphorus (P) effects deoxidation and, in addition, is an important element to form fine dispersoids having a particle diameter 200 nm or less with Fe and/or Mg to thereby improve the strength and the stress relaxation property of the copper alloy. If the content of P is less than 0.01 percent by mass, the fine dispersoids are not formed sufficiently. The content of P must be 0.01 percent by mass or more to effectively exhibit the effects such as the improvement in stress relaxation property. On the other hand, if the content of P exceeds 0.4 percent by mass, dispersoids are grown and become coarse to thereby reduce the bendability, the stress relaxation property, and the hot workability. Therefore, the content of P is specified to be within the range of 0.01 to 0.4 percent by mass.

### (Mg)

Magnesium (Mg) is an important element to form fine dispersoids having a particle diameter of 200 nm or less with P in the copper alloy to thereby improve the strength and the stress relaxation property. If the content of P is less than 0.1 percent by mass, the fine dispersoids are not formed sufficiently. The content of Mg must therefore be 0.1 percent by mass or more to effectively exhibit these effects. On the other hand, if the content of Mg exceeds 1.0 percent by mass, dispersoids are grown and become coarse to thereby reduce the strength, the bendability, and the stress relaxation property. Accordingly, the content of Mg is specified to be within the range of 0.1 to 1.0 percent by mass.

### (Ni, Co)

The copper alloy can further contain 0.01 to 1.0 percent by mass of at least one of Ni and Co. Nickel (Ni) and cobalt (Co), in common with Fe, precipitate as fine dispersoids of, for example, (Ni,Co)-P or (Ni,Co)-Fe-P in the copper alloy to improve the strength and the stress relaxation property. The total content of Ni and Co must be 0.01 percent by mass or more to effectively exhibit these effects. In contrast, if the total content of Ni and Co exceeds 1.0 percent by mass, dispersoids become coarse to thereby reduce the strength, the bendability, and the stress relaxation property. Accordingly, the total content of Ni and Co is specified to be within the range of 0.01 to 1.0 percent by mass.

### (Zn)

The copper alloy may further contain at least one of Zn and Sn. Zinc (Zn) is an effective element for improving the thermal ablation resistance and for preventing the thermal ablation of Sn plating and solder for use in junction of electronic components. The content of Zn is preferably 0.005 percent by mass or more to effectively exhibit these effects. In contrast, an excessively high content of Zn reduces the wettability and spreadability of molten Sn and solder and, in addition, significantly reduces the electrical conductivity. Accordingly, Zn is selectively contained at a content of 0.005 to 3.0 percent by mass, and preferably 0.005 to 1.5 percent by mass, so as to improve the thermal ablation resistance and to avoid reduction in electrical conductivity.

### (Sn)

Tin (Sn) is dissolved in the copper alloy and contributes to the improvement in strength. The content of Sn is preferably 0.01 percent by mass or more to effectively exhibit these effects. On the other hand, if the content of Sn is excessively high, the effect thereof is saturated. Conversely, the electrical conductivity is significantly decreased. In consideration of this point, Sn is selectively contained at a content within the range of 0.01 to 5.0 percent by mass and preferably 0.01 to 1.0 percent by mass.

### (Other elements)

The other elements are basically impurities and are preferably minimized. For example, impurity elements such as Al, Cr, Ti, Be, V, Nb, Mo, and W may often cause dispersoids to become coarse and induce a decreased electrical conductivity. Accordingly, the total content of these elements is preferably minimized to 0.5 percent by mass or less. Other minor elements in the copper alloy, such as B, C, Na, S, Ca, As, Se, Cd, In, Sb, Pb, Bi, and MM (misch metals), may cause a decreased electrical conductivity. The total content of these elements is therefore preferably minimized to 0.1 percent by mass or less.

More specifically, it is preferred that (1) the total content of Mn, Ca, Zr, Ag, Cr, Cd, Be, Ti, Co, Ni, Au, and Pt is 1.0 percent by mass or less, and that (2) the total content of Hf, Th, Li, Na, K, Sr, Pd, W, S, Si, C, Nb, Al, V, Y, Mo, Pb, In, Ga, Ge, As, Sb, Bi, Te, B, and misch metals is 0.1 percent by mass or less.

### (Dispersoid distribution)

Next, the distribution of dispersoids in the copper alloy is specified as follows so to achieve the high stress relaxation property and the high bendability.

### (Coarse dispersoids)

The coarse dispersoids having a particle diameter exceeding 200 nm in the copper alloy accelerate recrystallization in a hot environment to thereby reduce the stress relaxation property, cause breakage in deformation and promote crack propagation to thereby reduce the bendability, regardless of the composition thereof. Consequently, the volume fraction of coarse dispersoids having a particle diameter exceeding 200 nm in the copper alloy should be minimized to 5 percent by mass or less, regardless of the composition of the dispersoids.

### (Mg-P particles)

Of dispersoids having a particle diameter of 200 nm or less, those containing Mg and P (Mg-P particles) are specified to have an average particle diameter of 5 nm or more and 50 nm or less. These fine Mg-P particles highly contribute to inhibiting the dislocation migration and the grain growth and to the improvement in bendability and stress relaxation property.

According to the present invention, Mg-P particles having a particle diameter exceeding 200 nm are minimized and Mg-P particles having a particle diameter of 200 nmor less are specified to have the above-specified average particle diameter. The Mg-P particles having a particle diameter exceeding 200 nm are excluded from the calculation of the average particle diameter. This is because Mg-P particles having a particle diameter exceeding 200 nm shouldbe minimized, and fine Mg-P particles highly contributing to the improvement in bendability and stress relaxation property should be increased.

If the average particle diameter of dispersoids having a particle diameter of 200 nm or less and containing Mg and P exceeds 50 nm, the dislocation migration and the grain growth are not effectively inhibited. Consequently, the upper limit of the average particle diameter of the dispersoids mainly containing Mg and P is specified to be 50 nm. In contrast, if the average particle diameter of the dispersoids containing Mg and P is less than 5 nm, the particles do not effectively contribute to the inhibition of the dislocation migration and the grain growth and fail to improve the stress relaxation property and the bendability. Accordingly, the lower limit of the average particle diameter of the dispersoids mainly containing Mg and P is specified to be 5 nm.

### (Fe-P particles)

Of dispersoids having a particle diameter of 200 nm or less, dispersoids mainly containing Fe and P (Fe-P particles) having an average particle diameter of 1 to 20 nm exhibit significantly higher pinning force to inhibit the migration and disappearance of dislocation than coarse dispersoids. Accordingly, the average particle diameter of dispersoids having a particle diameter of 200 nm or less and containing Fe and P is within the range of 1 nm or more and 20 nm or less, for further improving the bendability and the stress relaxation property.

When the copper alloy further comprises at least one of Ni and Co, these elements form dispersoids containing Ni and/or Co, such as (Ni,Co)-P and (Ni, Co) -Fe-P particles in the copper alloy. The dispersoids containing Ni and/or Co preferably have an average particle diameter of 1 nm or more and 20 nm or less for further improving the bendability and the stress relaxation property, as in the Fe-P particles.

However, Ni/Co dispersoids containing Fe, such as (Ni, Co) -Fe-P particles, are substantially included in the "Fe-P particles" as used herein. If dispersoids containing Ni and/or Co other than the Fe-P particles, such as (Ni,Co)-P particles, are present, they can be refined as a result of refining of the Fe-P particles typically by the after-mentioned preferred production method. Accordingly, even when the copper alloy further comprises at least one of Ni and Co, the dispersoids containing Ni and/or Co are not specified and determined, and the Fe-P particles are specified as representative.

In the present invention, Fe-P particles having a particle diameter exceeding 200 nm are minimized, and the average particle diameter of the Fe-P particles having a particle diameter of 200 nm or less is specified within the above range. Fe-P particles having a particle diameter exceeding 200 nm are excluded from the calculation of the average particle diameter. This is because fine Fe-P particles highly contributing to the improvement in bendability and stress relaxation property should preferably be increased, as in the Mg-P particles.

If the average particle diameter of the dispersoids mainly containing Fe and P exceeds 20 nm, the pinning force decreases. Accordingly, the preferred upper limit of the average particle diameter of the dispersoids mainly containing Fe and P is 20 nm.

In contrast, if the average particle diameter of the dispersoids mainly containing Fe and P is less than 1 nm, such particles cannot be detected and determined even using a transmission electron microscope at a magnification of 100000 times and may have a low pinning force. Consequently, the preferred lower limit of the average particle diameter of the dispersoids mainly containing Fe and P is 1 nm.

These fine Mg-P particles and fine Fe-P particles (dispersoids) are formed, for example, in annealing after cold rolling in the production of the copper alloy. Specifically, these fine dispersoids are compound phases finely precipitated from the parent phase as a result of annealing.

The fine dispersoids are thereby different from coarse dispersoids formed upon casting and present in the copper alloy. Such fine dispersoids in the copper alloy can only be observed, for example, with a transmission electron microscope at a magnification of 100000 or more.

In other words, these dispersoids containing Fe and P and having an average particle diameter of 1 nm or more and 20 nm or less and dispersoids containing Mg and P and having an average particle diameter of 5 nm or more and 50 nm or less can be identified by the observation of the copper alloy with a transmission electron microscope at a magnification of 100000. This observation enables distinction between Mg-P particles each containing Mg and P in a total content of 60% or more of the total components and the other particles, distinction between Fe-P particles containing Fe and P in a total content of 60% or more of the total components and the other particles, and identification of dispersoids containing Ni and/or Co.

The average particle diameters of the Mg-P particles and the Fe-P particles each having a particle diameter of 200 nm or less are determined in the following manner by observing the microstructure with a transmission electron microscope (TEM) at a magnification of 100000. Initially, the largest diameter of each dispersoid in the microstructure in a visual field 1µm long 1 µm wide (1 µm²) of TEM is measured as the particle diameter d of each dispersoid.

Next, the total areal ratio of all these dispersoids having a particle diameter d exceeding 200 nm is determined. The total areal ratio is defined as the volume fraction of dispersoids each having a particle diameter exceeding 200 nm in the present invention.

The Fe-P particles having a total content of Fe and P of 60% or more and the Mg-P particles having a total content of Mg and P of 60% or more are distinguished based on the total content of Fe and P, and the total content of Mg and P, respectively, in the following manner. A semiquantitative analysis by energy dispersive X-ray spectroscopy (EDX) using electron prove X-ray microanalysis (EPMA) is used herein. This technique is generally used for analyzing microstructures. Thus, the total content of Mg and P, and the total content of Fe and P in each dispersoid are determined. Particles containing 60% or more of Fe and P, and those containing 60% or more of Mg and P are identified as the Fe-P particles and the Mg-P particles, respectively.

The largest diameter of each of the Fe-P particles or Mg-P particles each having the particle diameter d of 200 nm or less is determined. The largest diameters are then averaged. Thus, the average particle diameter of the Fe-P particles or Mg-P particles each having a particle diameter of 200 nm or less is determined.

### (Production condition)

Preferable production conditions to make the copper alloy compatible with the above-described microstructure specified according to the present invention will be described below. The copper alloy of the present invention is basically a copper alloy sheet, and a strip prepared by cutting the sheet in a widthwise direction and a coil made from the sheet or strip are also included in the copper alloy of the present invention. The copper alloy of the present invention can be produced through the same process as the normal process, except for preferable conditions in the cold rolling and the annealing to attain the above-described microstructure specified according to the present invention. Therefore, the normal production process itself is in no need of being changed significantly.

That is, a copper alloy melt adjusted to have the above-described preferable chemical composition is cast. The resulting ingot is subjected to facing, and to heating or a homogenizing heat treatment. Thereafter, hot rolling is performed.

Water-quenching is preferably performed after the completion of hot rolling to prevent formation of coarse dispersoids having a particle diameter exceeding 200 nm at elevated temperatures.

Subsequently, cold rolling and annealing are performed to yield a copper alloy sheet having a desired thickness as the product.

For controlling the dispersion of the Mg-P particles and the Fe-P particles within the ranges specified in the present invention, it is effective to perform the annealing under the following conditions. The fine dispersoids herein are compound phases newly precipitated from the parent phase as a result of annealing. To precipitate these fine dispersoids, annealing is performed subsequent to cold rolling after hot rolling in the production of the copper alloy.

However, if the precipitation of dispersoids is to be increased by only one pass of annealing, the annealing temperature must be elevated, and such a high annealing temperature causes dispersoids to grow and to be coarse. Thus, the Mg-P particles and the Fe-P particles may have an excessively large average particle diameter exceeding the above-specified ranges.

Consequently, it is preferred to perform plural annealing passes while controlling the annealing temperature in each process to 430°C or lower. Thus, the desired precipitation of dispersoids is obtained, and the growth of the dispersoids is prevented to thereby yield the fine dispersoids. I f the annealing time (holding time) is excessively long, the dispersoids may grow and become coarse. Thus, an optimal annealing time is preferably set.

In addition, cold rolling is preferably performed between these annealing passes. The cold rolling increases lattice defects which serve as precipitation nuclei in the subsequent annealing and contribute to the formation of the fine dispersoids.

In consideration of these conditions, it is preferred to perform two cold rolling processes and two annealing processes between hot rolling and finish cold rolling in the production of the copper alloy so as to yield the fine dispersoids having the above configuration.

### Examples

The present invention will be illustrated in further detail with reference to several experimental examples below. Specifically, a series of thin copper alloy sheets was produced by a process comprising each two passes of cold rolling and annealing (hot rolling-cold rolling-primary annealing-cold rolling-secondary annealing-finish cold rolling) at a varying composition under varying annealing conditions (temperature and time). Properties such as the hardness, the electrical conductivity, and the bendability of these copper alloy sheets were evaluated.

Specifically, each copper alloy having the chemical composition shown in Table 1 was melted in a coreless furnace, and an ingot-making was performed by a semicontinuous casting method to yield an ingot 70 mm thick, 200 mm wide, and 500 mm long. The surface of each ingot was subjected to facing, followed by heating. Thereafter, hot rolling was performed to prepare a sheet 16 mm thick, and the resulting sheet was quenched in water from a temperature of 650°C or higher. Oxidized scale was removed and, thereafter, primary cold rolling (intermediate rolling) was performed. The resulting sheet was subjected to facing and, thereafter, to primary annealing and cold rolling. Subsequently, secondary annealing and finish cold rolling were performed, and then strain relieving annealing at a low temperature was performed to thereby yield a copper alloy sheet about 0.2 mm thick.

In each copper alloy shown in Table 1, the remainder of the composition other than the elements described in Table 1 was Cu. The total content of other elements, i.e., Al, Cr, Ti, Be, V, Nb, Mo, and W was 0.1 percent by mass or less. The total content of impurity elements such as B, C, Na, S, Ca, As, Se, Cd, In, Sb, Pb, Bi, and MM (misch metals) was also 0.1 percent by mass or less.

The temperature and the time (°C × hr) of each pass of annealing are shown in Table 1.

In each example, samples were cut from the thus produced copper alloy sheet, and the volume fraction (%) of dispersoids each having a particle diameter exceeding 200 nm, the average particle diameter (nm) of dispersoids having a particle diameter of 200 nm or less and containing Mg and P, and the average particle diameter (nm) of dispersoids having a particle diameter of 200 nm or less and containing Fe and P in the microstructure were determined by the above methods. The results are shown in Table 2.

Separately, samples were cut from the thus produced copper alloy sheet, the hardness and the electrical conductivity were measured, and a bending test and a stress relaxation property test were performed. The results are also shown in Table 2.

### (Measurement of hardness)

A measurement of hardness of the copper alloy sheet sample was performed at four points with a micro Vickers hardness meter by applying a load of 0.5 kg, and an average value thereof was taken as the hardness.

### (Measurement of electrical conductivity)

The copper alloy sheet sample was processed into a slip-shaped test piece of 10 mm in width and 300 mm in length by milling, an electric resistance was measured with a double bridge resistance meter, and the electrical conductivity was calculated by an average cross-sectional area method.

### (Evaluation of bendability)

A bending test of the copper alloy sheet sample was performed in conformity with Japan Copper and Brass Association Standard. A test piece of 10 mm in width and 30 mm in length was taken from each sample, Good Way bending (the bending axis is perpendicular to the rolling direction) was performed, and the presence or absence of cracking at the bending portion was visually observed under an optical microscope at a magnification of 50 times. The bendability was evaluated according to the following criteria: Good: no cracking, Fair: slight cracking, Failure: apparent cracking.

### (Stress-relaxation resistance)

Each test piece was heated and held at 150°C for 1000 hours and the stress relaxation property of the test piece was evaluated according to the method of Electronics Materials Manufacturers Association of Japan Standard (EMAS-3003). Specifically, one side of the test piece after heating was held, and the stress under a load of 80% of the 0.2% proof stress as an initial stress was determined. The stress relaxation ratio (%) was determined according to the following equation: Stress relaxation ratio (%) = { [ (Stress of the test piece after heating) - (Stress of the test piece before heating)] / (Stress of the test piece before heating) } x 100. This test is performed to determine the change in stress typically of a terminal when held at high temperatures under a constant strain for a longtime. An alloy having a lower relaxation ratio is evaluated as having a higher stress relaxation resistance. The stress relaxation property in parallel with the rolling direction was evaluated.

Table 1 shows that Inventive Samples 1, 2, 4 and 6 to 13 are copper alloys having compositions satisfying the requirements in the present invention and have been produced under preferred conditions in which each two passes of cold rolling and annealing are conducted and the annealing temperature in each pass is set at 430°C or lower.

Inventive Samples 1, 2, 4 and 6 to 13 have a volume fraction of dispersoids each having a particle diameter exceeding 200 nm of 5% or less, in which dispersoids containing Mg and P have an average particle diameter of 5 nmormore and 50 nmor less, and dispersoids containing Fe and P have an average particle diameter of 1 nm or more and 20 nm or less.

Consequently, Inventive Samples 1, 2, 4, and 6 to 13 have a high strength and a high electrical conductivity of a proof stress of 400 MPa ormore, a hardness of 135 Hv or more, and an electrical conductivity of 60% IACS or more and are excellent in bendability and stress relaxation property.

In contrast, the copper alloy of Comparative Sample 14 has an Fe content lower than the lower limit of 0.01 percent by mass. This copper alloy has Mg and P contents satisfying the requirements in the present invention and has been produced under preferred conditions including the annealing temperatures. Thus, it has an average particle diameter of dispersoids containing Mg and P satisfying the requirement in the present invention, thereby has excellent bendability and stress relaxation property, but has a low strength. It fails to achieve a high strength and a high electrical conductivity.

The copper alloy of Comparative Sample 15 has an Fe content higher than the upper limit of 1.0 percent by mass. This copper alloy has Mg and P contents satisfying the requirements in the present invention and has been produced under preferred conditions including the annealing temperatures. Thus, it has an average particle diameter of dispersoids containing Mg and P satisfying the requirement in the present invention, but has a volume fraction of dispersoids having a particle diameter exceeding 200 nm exceeding 5% and thereby shows not only a low strength but also a low bendability and a low stress relaxation property.

The copper alloy of Comparative Sample 16 has a P content lower than the lower limit of 0.01 percent by mass. This copper alloy has been produced under preferred conditions including the annealing temperatures and thereby has an average particle diameter of dispersoids containing Mg and P satisfying the requirement in the present invention. However, it has a low stress relaxation property, since the insufficient P content invites an insufficient absolute quantity of fine dispersoids containing Mg and P.

The copper alloy of Comparative Sample 17 has a P content higher than the upper limit of 0.4 percent by mass. Although the alloy has been produced under preferred conditions including the annealing temperatures, it contains coarse dispersoids containing Mg and P having an average particle diameter exceeding the upper limit. In addition, the alloy has a markedly low electrical conductivity because of excessive P dissolved to form a solid solution and is low in strength, bendability, and stress relaxation property.

The copper alloy of Comparative Sample 18 has a Mg content lower than the lower limit of 0.1 percent by mass. This copper alloy has been produced under preferred conditions including the annealing temperatures and thereby has an average particle diameter of dispersoids containing Mg and P satisfying the requirement in the present invention. However, it has a low bendability and a low stress relaxation property because of the insufficient absolute quantity of fine dispersoids containing Mg and P.

The copper alloy of Comparative Sample 19 has a Mg content higher than the upper limit of 1.0 percent by mass. Although the alloy has been produced under preferred conditions including the annealing temperatures, it contains coarse dispersoids containing Mg and P having an average particle diameter exceeding the upper limit, has a volume fraction of dispersoids having a particle diameter exceeding 200 nm exceeding 5%, and thereby is low in strength, bendability, and stress relaxation property.

The copper alloy of Comparative Sample 20 has a composition within the range specified in the present invention, but it has been subjected to primary annealing at an excessively high annealing temperature exceeding 430°C, although the secondary annealing temperature is lower than 430°C. The resulting copper alloy contains coarse dispersoids containing Mg and P and coarse dispersoids containing Fe and P each having an average particle diameter higher than the upper limit and has a volume fraction of dispersoids having a particle diameter exceeding 200 nm exceeding 5%. Consequently, it has a low strength, a low bendability, and a low stress relaxation property.

The copper alloy of Comparative Sample 21 has a composition within the range specified in the present invention, but it has been subjected to primary annealing for an excessively long time, although the temperature therein is lower than 430°C. The resulting copper alloy contains coarse dispersoids containing Mg and P and coarse dispersoids containing Fe and P each having an average particle diameter higher than the upper limit and has a volume fraction of dispersoids having a particle diameter exceeding 200 nm exceeding 5%. Consequently, it has a low strength, a low bendability, and a low stress relaxation property.

The copper alloy of Comparative Sample 22 has a composition within the range specified in the present invention, but it has been subjected to primary annealing at an excessively low temperature. The copper alloy is thereby low not only in electrical conductivity but also in bendability and stress relaxation property due to insufficient absolute quantities of fine dispersoids containing Mg and P and fine dispersoids containing Fe and P.

The copper alloy of Comparative Sample 23 has a composition within the range specified in the present invention, but it has been subjected to secondary annealing at an excessively high annealing temperature exceeding 430°C, although the primary annealing temperature is lower than 430°C. The resulting copper alloy contains coarse dispersoids containing Mg and P and coarse dispersoids containing Fe and P each having an average particle diameter higher than the upper limit and has a volume fraction of dispersoids having a particle diameter exceeding 200 nm exceeding 5%. Consequently, it has a low strength, a low bendability, and a low stress relaxation property.

The copper alloy of Comparative Sample 24 has a composition within the range specified in the present invention, but it has been subjected to secondary annealing for an excessively long time, although the temperature therein is lower than 430°C. The resulting copper alloy contains coarse dispersoids containing Mg and P and coarse dispersoids containing Fe and P each having an average particle diameter higher than the upper limit and has a volume fraction of dispersoids having a particle diameter exceeding 200 nm exceeding 5%. Consequently, it has a low strength, a low bendability, and a low stress relaxation property.

The copper alloy of Comparative Sample 25 has a composition within the range specified in the present invention, but it has been subjected to secondary annealing at an excessively low temperature. The copper alloy is thereby low not only in electrical conductivity but also in bendability and stress relaxation property due to insufficient absolute quantities of fine dispersoids containing Mg and P and fine dispersoids containing Fe and P.

When each one pass of cold rolling and annealing is carried out and the annealing temperature is higher than 430°C, the annealing time is excessively long, or the annealing temperature is excessively low, the results are similar to those in Comparative Samples 20 to 25.

These results corroborate the significance of the critical composition and dispersoids of the copper alloy of the present invention to achieve high strength and high electrical conductivity, as well as excellent bendability and excellent stress relaxation property, and the significance of preferable production conditions to attain the requirements in dispersoids.

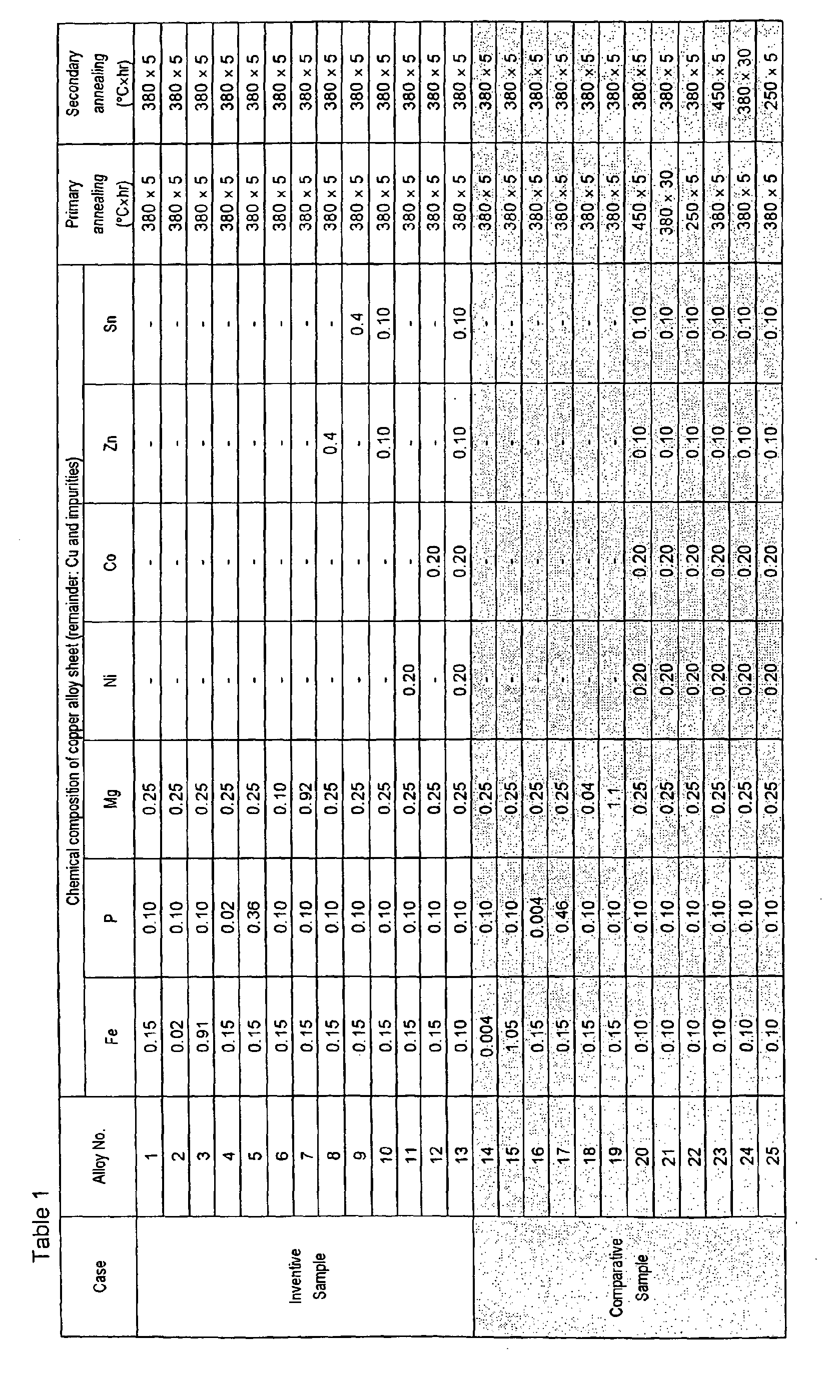

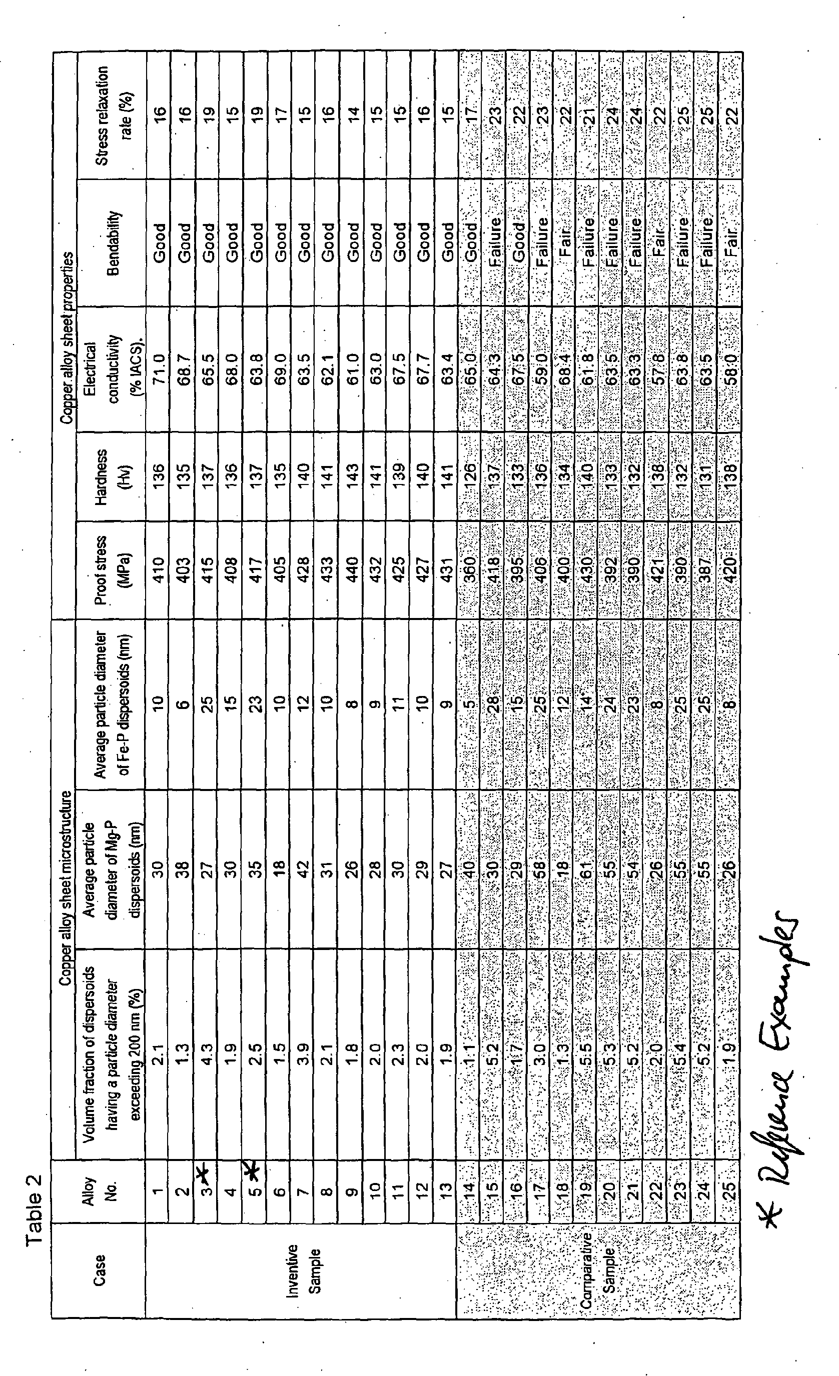

Table 3 shows another experimental example in which copper alloys have amounts of the selectively added elements and/or the other elements (impurities) exceeding the preferred upper limits. These samples are thin copper alloy sheets 0.2 mm thick produced under the same conditions as in the above experimental example (the conditions for the inventive samples). The properties, such as hardness, electrical conductivity, and bendability, of these thin copper alloy sheets were determined by the procedure of the above experimental example. The results are shown in Table 4.

Inventive Sample 2 6 in Table 3 corresponds to Inventive Sample 1 of the above experimental example in Tables 1 and 2, in which the contents of the other elements (impurity elements) are further specified.

Inventive Sample 27 has a high total content of the elements of Group A in Table 3, i.e., Mn, Ca, Zr, Ag, Cr, Cd, Be, Ti, Co, Ni, Au, and Pt.

Inventive Sample 28 has a high total content of the elements of Group B in Table 3, i.e., Hf, Th, Li, Na, K, Sr, Pd, W, S, Si, C, Nb, Al, V, Y, Mo, Pb, In, Ga, Ge, AS, Sb, Bi, Te, B, and misch metals, exceeding 0.1 percent by mass.

Inventive Samples 29 and 30 each have a high Zn content. Inventive Samples 31 and 32 each have a high Sn content.

These Inventive Samples 27 to 32 have contents of principal elements of Fe, P, and Mg within the specified ranges in the present invention and have been produced under the preferred conditions. These copper alloys satisfy the requirements on dispersoids in the present invention and have a high proof stress, a high hardness, an excellent bendability, and an excellent stress relaxation property. They, however, have a lower electrical conductivity than Inventive Sample 26 (corresponding to Inventive Sample 1 in Tables 1 and 2), due to high contents of the other elements.

Comparative Samples 33 and 34 have Zn and Sn contents higher than the preferred upper limits. These copper alloys have contents of principal elements of Fe, P, and Mg within the specified ranges in the present invention and have been produced under the preferred conditions, satisfy the requirements on dispersoids in the present invention and have a high proof stress, ahighhardness, anexcellent bendability, and an excellent stress relaxation property. However, they have a markedly lower electrical conductivity than Inventive Samples Sample 27 to 32, due to high Zn and Sn contents.

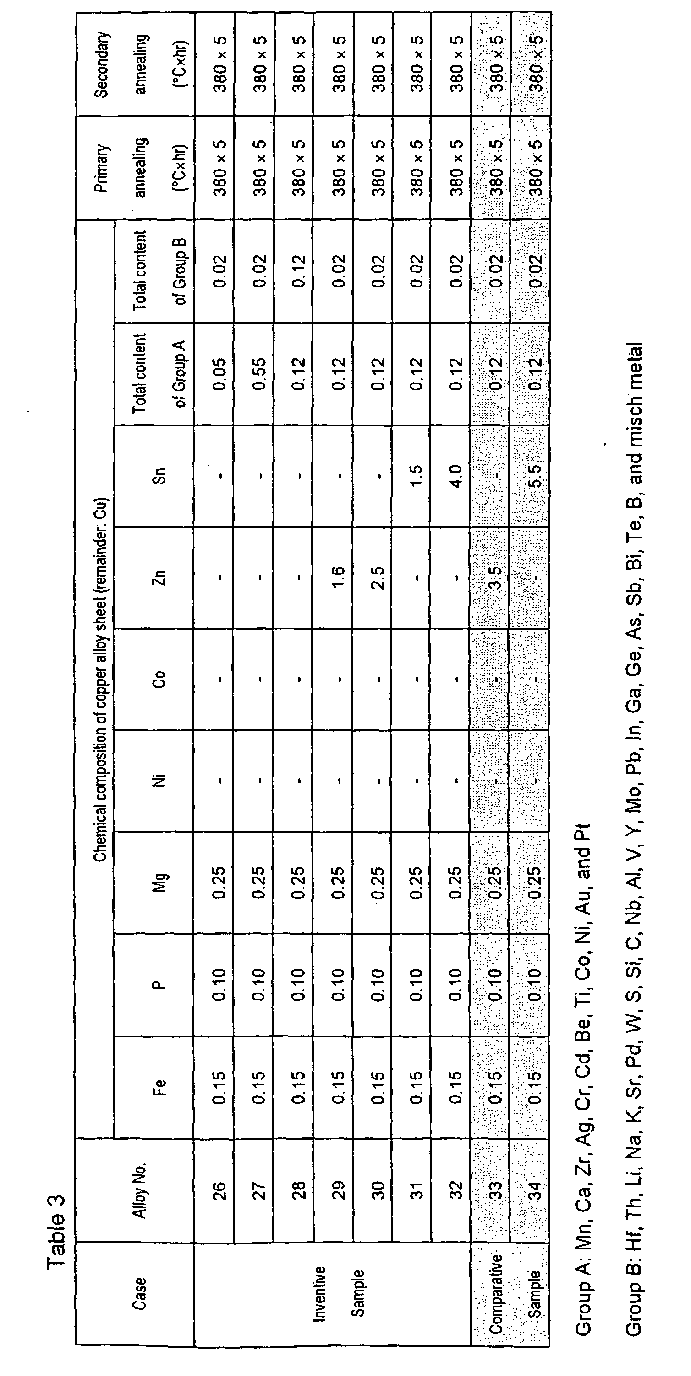

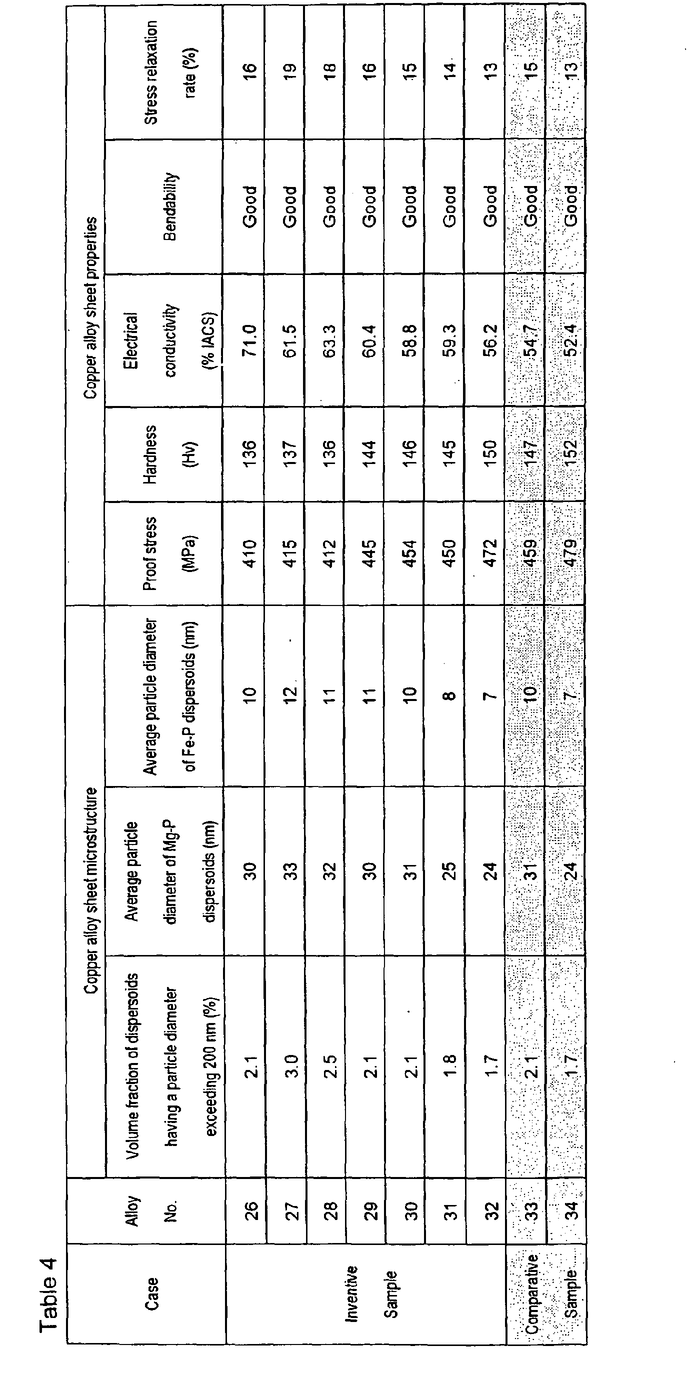

As is described above, according to the present invention, the Cu-Fe-P alloy which has excellent bendability and excellent stress relaxation property can be provided without loss of the high strength and the high electrical conductivity. Consequently, the resulting copper alloy canbe applied to lead frames, connectors, terminals, switches, relays, and other uses, in addition to IC lead frames for semiconductor devices, to serve as a downsized and lightweight electric and electronic component, in which high strength, high electrical conductivity, excellent bendability capable of enduring sharp bending and excellent stress relaxation property are required.

## Claims

1. copper alloy having bendability and stress relaxation property and comprising, in wt.%:
0.01 to 1.0% Fe,
0.01 to 0.4% P,
0.1 to 1.0% Mg,
optionally 0.01 to 1.0% of at least one of Ni and Co, and/or
0.005 to 3.0% Zn and/or
0.01 to 5.0% Sn and/or
1.0% or less of a total content of Mn, Ca, Zr, Ag, Cr, Cd, Be, Ti, Co, Ni, Au and Pt
and/or
0.1% or less of a total content of Hf, Th, Li, Na, K, Sr, Pd, W, S, Si, C, Nb, Al, V, Y,
Mo, Pb, In, Ga, Ge, As, Sb, Bi, Te, B, and misch metal and
the remainder being Cu and inevitable impurities,
wherein the volume fraction of dispersoids with particle diameters exceeding 200 nm is 5% or less, the dispersoids having a particle diameter of 200 nm or less and containing Mg and P have an average particle diameter of 5 to 50 nm and the dispersoids having a particle diameter of 200 nm or less and containing Fe and P have an average particle diameter of 1 to 20 nm.

## Patentansprüche

1. Kupferlegierung mit Biegbarkeit und Spannungsentlastungseigenschaft, und umfassend, in Gew.-%:
0,01 bis 1,0% Fe,
0,01 bis 0,4% P,
0,1 bis 1,0% Mg,
gegebenenfalls 0,01 bis 1,0% von mindestens einem von Ni und Co, und/oder
0,005 bis 3,0% Zn, und/oder
0,01 bis 5,0% Sn, und/oder
1,0% oder weniger eines Gesamtgehalts von Mn, Ca, Zr, Ag, Cr, Cd, Be, Ti,
Co, Ni, Au und Pt, und/oder
0,1 % oder weniger eines Gesamtgehalts von Hf, Th, Li, Na, K, Sr, Pd, W, S, Si,
C, Nb, Al, V, Y, Mo, Pb, In, Ga, Ge, As, Sb, Bi, Te, B und Mischmetall, und
wobei der Rest Cu und unvermeidliche Verunreinigungen sind,
wobei der Volumenanteil von Dispersoiden mit Teilchendurchmessern, die 200 nm überschreiten, 5% oder weniger ist, wobei die Dispersoiden, die einen Teilchendurchmesser von 200 nm oder weniger aufweisen und Mg und P enthalten, einen mittleren Teilchendurchmesser von 5 bis 50 nm aufweisen, und die Dispersoiden, die einen Teilchendurchmesser von 200 nm oder weniger aufweisen und Fe und P enthalten, einen mittleren Teilchendurchmesser von 1 bis 20 nm aufweisen.

## Revendications

1. Alliage de cuivre ayant une aptitude au pliage et une propriété de relaxation de contrainte et comprenant, en % en poids :
de 0,01 à 1,0 % de Fe,
de 0,01 à 0,4 % de P,
de 0,1 à 1,0 % de Mg,
facultativement, de 0,01 à 1,0 % d'au moins l'un de Ni et Co, et/ou
de 0,005 à 3,0 % de Zn et/ou
de 0,01 à 5,0 % de Sn et/ou
1,0 % ou moins d'une teneur totale en Mn, Ca, Zr, Ag, Cr, Cd, Be, Ti, Co, Ni, Au et Pt et/ou
0,1 % ou moins d'une teneur totale en Hf, Th, Li, Na, K, Sr, Pd, W, S, Si, C, Nb, Al, V, Y, Mo, Pb, In, Ga, Ge, As, Sb, Bi, Te, B et un mishmétal et
le reste étant du Cu et des impuretés inévitables,
dans lequel la fraction volumique des dispersoïdes avec des diamètres particulaires dépassant 200 nm est de 5 % ou moins, les dispersoïdes ayant un diamètre particulaire de 200 nm ou moins et contenant du Mg et P a un diamètre particulaire moyen allant de 5 à 50 nm et les dispersoïdes ayant un diamètre particulaire de 200 nm ou moins et contenant du Fe et P a un diamètre particulaire moyen allant de 1 à 20 nm.
